# EUROPEAN PATENT APPLICATION

(11) **EP 3 305 947 A1**
(43) Date of publication of application: **11.04.2018**
(21) Application number: 16724471.4
(22) Date of filing: 20.04.2016
(51) Int. Cl.: C30B 29/06, C30B 13/22, C30B 13/00, C30B 15/14

(54) **MELTING METHOD DURING FLOATING-ZONE GROWTH OF SILICON**

(30) Priority: 26.05.2015 LV 150048
(71) Applicant: Kravtsov, Anatoly, 1011 Riga (LV)
(72) Inventor: Kravtsov, Anatoly, 1011 Riga (LV)
(74) Representative: Zaboliene, Reda
(86) International application number: PCT/IB2016/052236
(87) International publication number: WO 2016/189402

(57) **Abstract**

The invention relates to the production of silicon, for example, for the power microelectronics or the photoelectric industry including the manufacturing of solar cells. The invention solves the problem of obtaining silicon in the form of high-purity rods made of native silicon of varying quality and forms suitable by their electrical, mechanical and geometrical properties for growing single crystals of various purposes using the float-zone melting method.

The proposed method, which implementation is shown on Fig. 1 and Fig. 2, shall be realized as follows: silicon is putted into the container, having a thermal insulator (1) and the cooling device (2), and placed in the melting chamber of the apparatus, produce a vacuum and melt, using electron beams (3) for heating. In addition, beams are moved aside up to the specified diameter and start scanning, forming an annular heating zone. A heating zone diameter (5) selected in a way to obtain the required result - to melt down all silicon in container or to maintain part of the initial not melted mass (7) between the molten zone (6) and the walls of the container. After melting of particular part of initial mass (7), the crystal seed (8) is inserted into the container, coupled with a melt and grow the rod (9) of required diameter. The growing process is managed by changing the stretching speed (V) and a heating intensity (3), besides is kept at a constant heating (3) the annular zone (4) diameter. Focal spot scanning path (5) by electron beams together form a shape that is close to the required diameter of the ring and form sufficient heat symmetry field, in order to obtain the cylindrical rod (9).

## Description

### THE FIELD OF THE INVENTION

The invention relates to the production of silicon, for example, for the power microelectronics or the photoelectric industry including the manufacturing of solar cells. The purpose of this production is obtaining dislocation-free silicon single-crystals from the source rods of relevant quality.

### THE BACKGROUND OF THE INVENTION AND PRIOR ART

The process of obtaining silicon single-crystals using a float-zone melting method includes two important stages: obtaining the source rod of specified dimensions with the required properties and vertical (predominantly induction) float-zone melting. The source rod fit for growing dislocation-free single-crystals is obtained by depositing from the gas phase during the silane decomposition process in hydrogen or by growing from the melt. The source rod must have the impurity content requested by the customer, a cylindrical shape with minimal ellipticity - the difference between the diameters of an ellipse in the rod's cross-section (less than 5 mm) and camber - less than acceptable value (usually 5 mm/metre of length), a smooth surface and dimensions equal or almost equal to the size of the desired single crystal. In addition, the rod should be free of cracks.

Single crystal growth occurs in gas environment, so the ability to manage the composition of the impurities is limited, namely: the removal of oxygen and impurities that have very low rates of distribution is possible and the introduction of impurities - doping - is possible in a fairly wide range. p

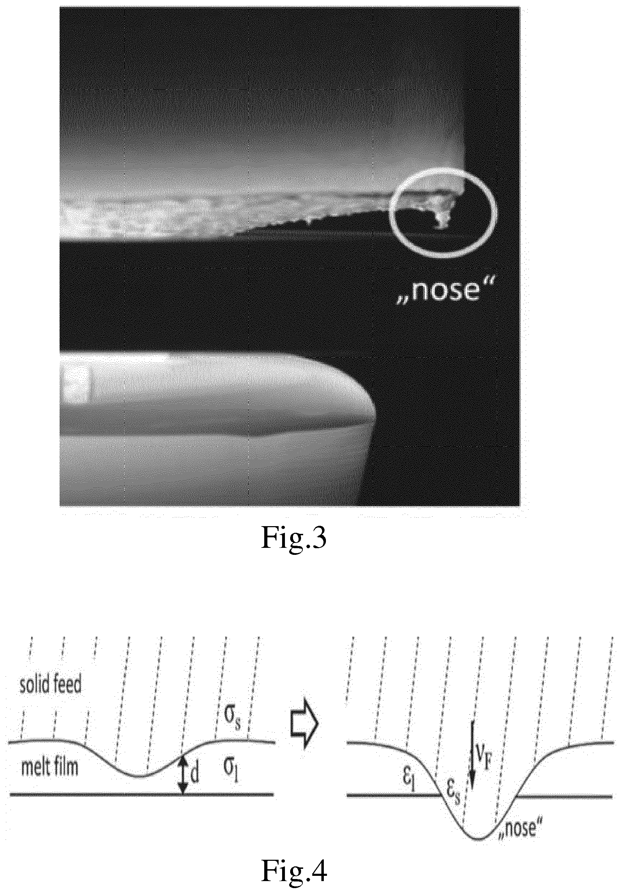

Currents induced in the treated rod during induction heating have the greatest density at some distance from the surface (penetration depth). All the irregularities occurring due to the granular structure of the source rod and having size less than the penetration depth of the current, i.e. about 0.8 (2.8 MHz) or 1.5 mm (1.76 MHz) depending on the current frequency, remain unheated. Such irregularities (see Figure 3) are approaching the melting inductor coil under high voltage and lead to electrical discharge and abnormal termination of the growing process. Violation of the cylindrical shape, the presence of buckles on the surface, the presence of ellipticity or camber more than 5 mm leads to unsymmetrical melting of the source rods. As a consequence, the melt droplets are formed on the melting surface and do not flow down into the zone (Figure 4). These melt droplets have a considerable volume and may cause spillage of the melt zone upon entering. When depositing silicon rod in the gas phase, the source rod with a diameter of several millimetres is heated by channelling current through it. The heat dissipation occurs from the surface of the growing rod. Due to heating from the neighbouring rods, the heat dissipation isn't uniform and thermomechanical tensions are formed within the rod and grow with increasing diameters of the rods. As a result, with the increase of diameter of the rods the task of ensuring the absence of cracks in them becomes more difficult. The rods obtained by deposition from the gas phase can be improved by prior passing of the molten zone in a vacuum with obtaining a polycrystalline rod without ellipticity, sagging, with a smooth surface and diameter close to one necessary for growing single-crystals. In this case, the requirements to the source rod prior to the preliminary passing of the zone in a vacuum are toned down insignificantly and the presence of the cracks in the rod and its dimensions close to the requested for single-crystals is preserved. It is important that despite the shortcomings, silicon with the lowest content of impurities can be obtained exactly by deposition from the gas phase.

As an alternative to obtaining silicon rods from the gas phase using the deposition method, their pulling on the seed crystal from the crucible is employed using polycrystalline silicon in the form of pieces, for which the requirements to the rods can be considered irrelevant: the absence of cracks, ellipticity, presence of cambers, the only important factor is the composition of impurities. However, additional impurities are introduced during the process of growing from the crucible and the obtained rods dissatisfy almost all spheres of applications of the single-crystals grown by float-zone melting, except for low-voltage converter equipment and solar energy. On the other hand, the rods can be obtained without using heating from the graphite via the crucible, but through applying inductive or electron-beam heating inside the volume of the processed silicon.

A number of methods of producing polycrystalline rods from the gas phase in order to optimise subsequent growing of the single-crystals using the float-zone melting method are known. The method of obtaining polycrystals from the gas phase in accordance with patent No. EP0445036 [1] utilises a single-crystal source rod to ensure a flat surface of the deposited rod. As the shortcomings of this method, it should be pointed out that in the process the cylindrical form of the rods and absence of cracks in them are not provided.

The method of obtaining polycrystals of the gas phase under the Patent No. US 6544333 [2] is known, in which it is proposed to perform heating using high-frequency currents in the process of deposition from the gas phase to concentrate heat emission on the surface of the rod and not in the middle of it, in order to obtain rods without thermomechanical tensions that cause cracks. According to the authors, this method will ensure creation of the rods without the stresses of a diameter exceeding 150 mm, including up to 300 mm. This method does not preclude mutual influence of the rods on each other (resulting in the incorrect form of cross-section). Despite the fact that the original patent holder Advanced Silicon Materials LLC was the main producer of polycrystalline rods for float-zone melting, the method is still not implemented on an industrial scale. REC Silicon company, the new owner of this production, still produces rods with diameters up to 170 mm (*http:*//*www.recsilicon.com*/*products*/*electronic-grade-polysilicon*/*float-zone-polysilicon*/), while the production of rods with a diameter of more than 200 mm is required.

An alternative method of obtaining silicon single-crystals utilising the float-zone melting method is known, which bypasses the stage of obtaining the source rod, accordingly to patent No. US 5108720 [3]. According to this patent, the applicant - Hemlock Semiconductor Corporation, one of the leading producers of polysilicon - planned to obtain single crystals from powdered silicon, which heats up, melts and allows growing a single crystal when fed into the molten zone. The disadvantages of this method include the complexity of reproducing the process associated with the processing of bulk material in a strong magnetic field and inability to stabilise the thermal conditions of the melted material.

Several methods of growing the single crystals out of the melt without contacting with the container (crucible) are known, in which the container is absent or cooled. These known methods are used for the cultivation of source rods and further growing of the single-crystals using the float-zone melting method. In accordance to the patent No. 3494804 (US) published 10.02.1970 [4], silicon is heated by at least three focused arched electron beams forming a ring-shaped heating area with a diameter 3-4 times larger than the diameter of a pulled crystal. As a source material, the method involves using both the rod of diameter larger than the diameter of the growing ingot and a water-cooled copper device in which the melt is formed. According to the method under patent No. 4133969 (US) published 09.01.1979 [5], the ring-shaped heating area is formed by the inductor while processed silicon is also being placed in a water-cooled tank and a part of silicon adjacent to the tank is not melted. The methods under patents No. 5223077 (US) published 19.06.1993 [6] and No. 5268063 (US) published 07.12.1993 [7] provide using a cold crucible directly formed by the water-cooled inductor coated with materials of high dielectric strength and resistance to melt exposure. When increasing the diameters of grown crystals by more than 40 mm, melting of the original bed is almost impossible without the risk of its twinning with the crystal grown, as shown in the article of T.F. Ciszek "GROWTH OF 40 mm DIAMETER SILICON CRYSTALS BY A PEDESTAL TECHNIQUE USING ELECTRON BEAM HEATING", published in "Journal of crystal growth" No. 12 (1972), page 281-287 [8]. In all of these mentioned systems, the effect occurs with various diameters, but does not provide the possibility of growing crystals of a diameter exceeding 50-150 mm. In addition, these methods do not specify the required properties of the grown crystals for optimisation of the subsequent float-zone melting process.

The closest to the method proposed shall be a method in accordance with patent application No. EP0142666 [9] regarding the production of single-crystal silicon by the float-zone melting method using the source rods with a diameter that differs from the source rod by no more than 20%, obtained in the process of gas-phase growing at low growth rates or from the melt by the way of two-stage process of float-zone melting or growing of the source rod from the polysilicon lumps using the Czochralski method. The disadvantages of the gas-phase deposition process as described in the application No. EP0142666 are following: buildups in the form of surface irregularities, deviations from the cylindrical shape and thermomechanical tensions, which in turn lead to rod cracking as their diameter increase. Performing two passes of the molten zone on the source rod of insufficient quality causes high accident rate of the processes. Even in the case of accident-free outcome, the economic results of the process are reduced significantly. As a result, the cultivation of the rods utilising the Czochralski method finds expanding applications for growing the single-crystals with a diameter of 200 mm by using the float-zone melting method, as reflected even in the promotional materials of some companies, such as CFZ silicon of the Chinese company Tianjin Zhonghuan Semiconductor Co., Ltd (*http:*//*en.tjsemi.com*/*main*/*productdetails*_*s*_*1.aspx*). It means that a source rod is grown using the Czochralski method and a dislocation-free single-crystal is grown using the induction float-zone melting method. The disadvantage of this method is the impossibility to obtaining silicon with the resistance of more than 50 Ohm*cm due to impurities introduced in the melt from the crucible and graphite heater in the course of a standard process and an uncompetitive costs of applying the Czochralski method with the magnetic field. In addition, the process does not allow to recycle waste with low specific resistance (less than 0.1 Ohm*cm) for later use in solar energy.

### SUMMARY OF THE INVENTION

The goal of the invention is to obtain silicon in the form of high-purity rods made of source silicon of varying quality and forms, suitable by their electrical, mechanical and geometrical properties for growing single-crystals of various purposes using the float-zone melting method.

The technical result is that the source rod for growing of the single-crystal using the float-zone melting method is obtained by pulling the seed from the melt utilising electron-beam heating. Electron-beam heating occurs directly inside the container with silicon without the use of graphite and heat transfer through the walls of the container, thus preventing the main sources of impurities from contaminating the melt. Additionally, silicon with purity corresponding to quality requirements for the single crystals to be grown by float-zone melting method is used as a source raw material.

The technical result is achieved by the fact that in the production of the silicon single-crystals utilising float-zone melting method, which includes growing of the source rod by seeded pulling it from the melt, silicon is heated inside the container by minimum of two electronic beams to reduce or eliminate interaction of the melt with the container.
In this case, the focal heating spots made by electron beams move along the arcs of the specified radius not less than the diameter of the grown rod, in total corresponding to the central angle of not less than 340 degrees.
To obtain source rods with high specific electrical resistance, high-quality polycrystalline silicon or silicon residues formed after cutting of the single-crystals by float-zone melting method are used as source raw materials. During the process, any contact of the melt with the container from which the rod is to be grown is prevented. For that purpose, a container with a diameter of not less than 5 diameters of the grown rod is used, at the same time the entire process is carried out by applying 0.03-0.06 kW/cm² of power to the melt starting from the melting procedure until the end of rod growing.

The essence of the method (Figure 6) is that when the melt in a container is heated using electron-beam heating, the motion path of focal spots can be selected by setting such a diameter that the distribution of temperature in the melt will provide stable growth of the crystal with a set tapered shape followed by a cylindrical shape while a container wall temperature remains low, including such case when the inner surface of the container has a layer of unmelted source silicon with a thickness of 5-20 mm. For preferable temperature distribution control, the container diameter should be not less than 5 diameters of the grown source crystal.

### BRIEF DESCRIPTION OF THE DRAWINGS

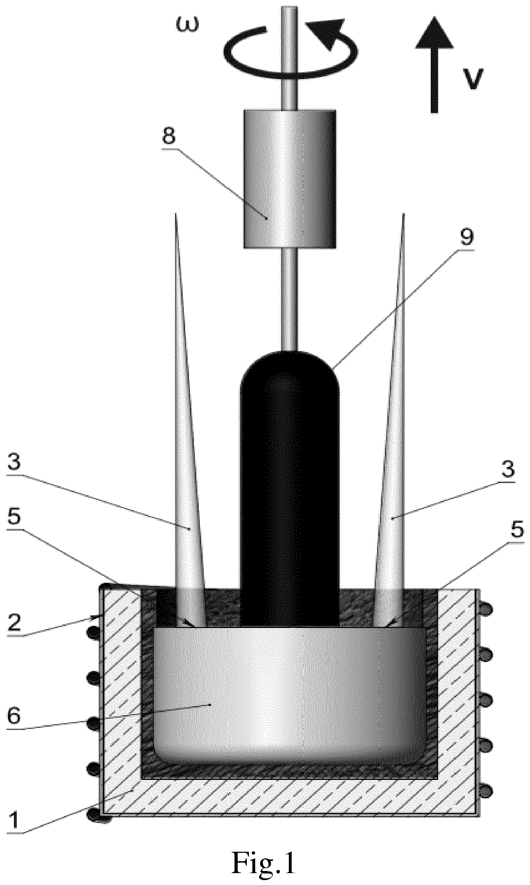

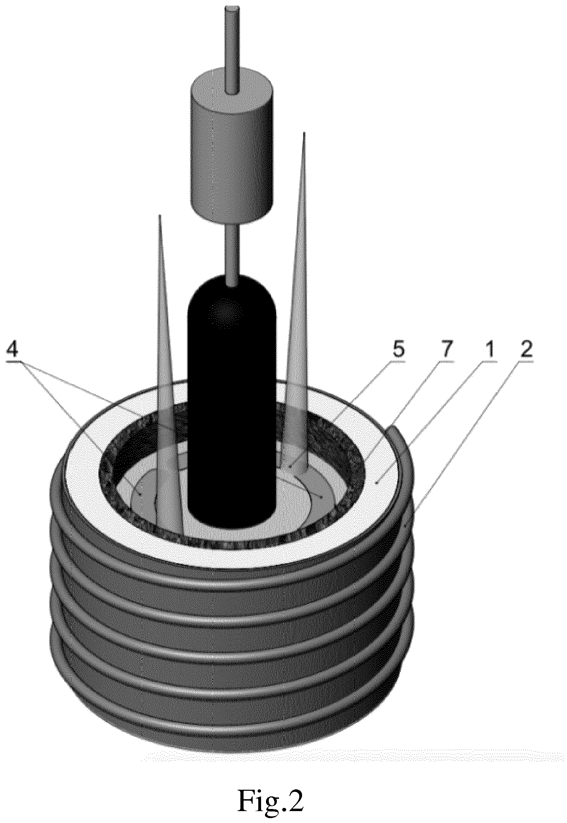

Figures 1 and 2 - Process flow diagram;
Figure 3 - Formation of unmelted elements of the source rod's surface;
Figure 4 - Diagram of formation of the melt droplets on the melting surface of the source rod;

### DETAILED DESCRIPTION OF THE INVENTION

The method is implemented as follows: silicon is placed in a container containing a thermal insulator (1) and a cooled device (2). Then the container is placed into the melting chamber of the apparatus with subsequent creation of a vacuum followed by melting utilising electron-beam heating (3). At the same time, the rays are spread to a specified diameter and scanning is started, forming a ring heating zone (4). The diameter of the focal spot heating\moving zone (5) is chosen in such a way as to achieve the desired result - to melt the entire silicon in the container or preserve a part of the unmelted original bed (7) between the molten zone (6) and container walls. After the melting of the specified part of the original bed (7), a seed crystal (8) is placed into the container; it contacts the melt and grown into a rod (9) of the required diameter. The growing process is controlled by modifying the speed of pulling (V) and intensity of heating (3), while ensuring the constant diameter of the ring heating (3) zone (4). Scan trajectories of the electron beam focal spots (5) together form the shape of a ring close to the ring of the required diameter and form the thermal field of a thermal symmetry sufficient for growing a cylindrical rod (9).

### 1. An example of implementation of this method

A container with an internal diameter 420 mm is stacked with polycrystalline silicon. The container is placed in a vacuum chamber of the device. After reaching residue pressure less than 1*10-4 mm Hg both electron-beam heaters are turned on, the power supplied is set to 1.2-1.3 kW per 1 kg of loaded silicon and electron beam scan mode is enabled along the arcs of a circle of 250-300 mm with periodic decrease of circle diameter to 50-100 mm. After the formation of the molten pool, scanning of focal spots made by electron beams is continued for 20-60 minutes ensuring the maximum radii of arcs, while at the same time providing retention of a layer of unmelted source silicon 5-20 mm thick on the inner surface of the container. Next, the supplied power is reduced by 20-50% and the seed crystal is introduced to the point when it contacts the melt followed by choosing the power optimal for growing. Further process is lead similar to the processes of growing from the crucible utilising the Czochralski method; for that purpose, the radii of the arcs formed by the moving focal spots are gradually increased up to a value not less than the diameter of the grown crystal and fixed afterwards. In this case, the central angle of arc coverage is not less than 340 circular degrees in total. The rod of 75 mm in diameter is grown with variable speed, starting with a rate of 2.5 mm/min and finishing at less than 2 mm/min, additionally the rod is rotated with a frequency of 10-15 rpm while the container remains stationary. During the growing process, the power applied to the melt is reduced from 60 to 40 kilowatts from 2 heaters in total as the crystal grows. The grown rod is cooled down, removed from the chamber of the vacuum device and its geometrical and electrophysical parameters are evaluated for their compliance with the parameters required to obtain a single-crystal. In these processes, specific electrical resistivity of the grown rod is acceptable and complies with reference parameters of loaded polycrystalline silicon. Next, the rod is prepared for the growing process; it can be treated mechanically and chemically, if necessary. After that, the rod is placed into the induction float-zone melting plant and a dislocation-free single-crystal is grown, which diameter differs from the diameter of the grown rod by no more than 20%. For this example, a single crystal of 65 mm in diameter was grown.

## Claims

1. A method of obtaining single-silicon crystals without dislocations and with minimal introduction of impurities during the production process, which includes pulling of the cylindrical source rod from the melt that minimally interacts with the cooled container and the subsequent growing of the single crystals with a diameter different from the diameter of the grown rod for no more than 20% by the induction float-zone melting method, **characterised in that** growing of the rod on the seed crystal is produced using electron-beam heating with at least two electron-beam heaters, which create focal heating spots moving on arcs with the radii not less than the diameter of the grown rod, in total corresponding to the central angle of not less than 340 degrees.

2. The method in accordance with Claim 1 is **characterised in that** the process is performed while excluding the contact of the melt with the container using a cooled container with a diameter of not less than 5 diameters of the grown rod.

3. The method in accordance with Claim 1 and/or 2 is **characterised in that** the process is performed while affecting the melt with power 0.03-0.07 kW/cm².

4. The method in accordance with Claim 2 and/or 3 is **characterised in that** the process is performed while keeping the layer of unmelted source silicon with thickness 5-20 mm on the inner surface of the container.

5. The method in accordance with any of the above mentioned Claim from 1 to 4 is **characterised in that** at the beginning of the process of obtaining the rod a cone is grown with an angle at the top optimal for growing single-crystals using the induction float-zone melting method.

6. The method in accordance with Claim 5 is **characterised in that** at the beginning of the process of obtaining the rod a cone is grown with an angle at the top 50-80 degrees.
